# FASCICULE DE BREVET EUROPEEN

(11) **EP 0 523 587 B1**
(45) Date de publication et mention de la délivrance du brevet: **25.05.1994**
(21) Numéro de dépôt: 92111883.2
(22) Date de dépôt: 13.07.1992
(51) Int. Cl.: H01S 3/19, H01L 33/00

(54) **Laser semi-conducteur à double canal et son procédé de réalisation**
Doppelkanal-Halbleiterlaser und sein Herstellungsverfahren
Double channel semiconductor laser and its method of production

(30) Priorité: 19.07.1991 FR 9109178
(43) Date de publication de la demande: 20.01.1993
(73) Titulaire: ALCATEL CIT, 75008 Paris (FR)
(72) Inventeur: Brillouet, François, F-92310 Sevres (FR); Garabedian, Patrick, F-91290 Arpajon (FR); Goldstein, Léon, F-92370 Chaville (FR); Pagnod-Rossiaux, Philippe, F-91180 St Germain les Arpajon (FR)
(74) Mandataire: Weinmiller, Jürgen

(56) Documents cités:
- EP-A- 0 161 016
- US-A- 4 947 400
- PATENT ABSTRACTS OF JAPAN vol. 14, no. 190 (E-91)18 Avril 1990 & JP-A-239 483
- JAPANESE JOURNAL OF APPLIED PHYSICS. vol. 25, no. 6, Juin 1986, PART II, TOKYO, JP pages 435 - 436, S.L. SHI et al.: "BH InGaAsP lasers with an LPE grown semi-insulating layer'
- PATENT ABSTRACTS OF JAPAN vol. 12, no. 261 (E-636)22 Juillet 1988 & JP-A-63 046 790
- NEUES AUS DER TECHNIK. no. 1, 20 Février 1987, WURZBURG DE, page 6: 'Eisenimplantierter DCPBH-Laser'
- PATENT ABSTRACTS OF JAPAN vol. 8, no. 250 (E-279)16 Novembre 1984 & JP-A-59 125 684

## Description

La présente invention concerne la réalisation d'un laser semi-conducteur à double canal.

La structure d'un tel laser est désignée internationalement par le sigle DCPBH découlant de l'appellation anglo-saxonne "Double Channel Planar Buried Heterostructure". Elle peut par exemple être réalisée à l'aide d'un matériau de base constitué de phosphure d'indium et d'un matériau actif comportant en outre de l'arséniure de gallium. Elle peut alors constituer un laser de pompage émettant à une longueur d'onde de 1 480 nm et utilisable dans des liaisons à fibres optiques de longue distance comportant des fibres amplificatrices dopées à l'erbium.

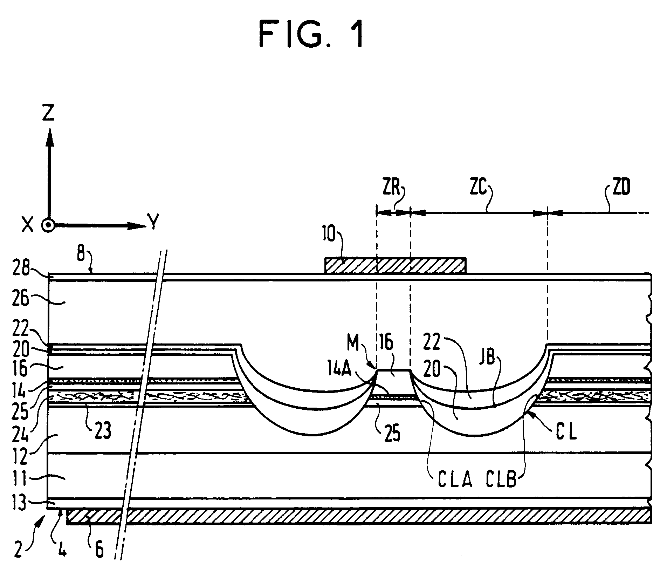

Un tel laser comporte les éléments suivants, qui sont communs, quant à leurs fonctions indiquées ci-après, à des lasers connus et à un laser selon la présente invention et qui, dans le cas de ce dernier laser, sont représentés en section transversale à la figure 1 :
- Une plaquette généralement semi-conductrice (2) ayant une continuité cristalline interne et présentant une épaisseur entre deux faces principales (4, 8). Cette plaquette définit une direction verticale (Z) qui est celle de cette épaisseur et deux directions longitudinale (X) et transversale (Y) qui sont horizontales et mutuellement perpendiculaires. Ces deux faces principales sont une face inférieure (4) revêtue d'une électrode inférieure (6) et une face supérieure (8) revêtue d'une électrode supérieure (10). Cette plaquette est constituée de couches qui se succèdent verticalement de la face inférieure à la face supérieure. Elle présente des zones diversifiées qui s'étendent longitudinalement et se juxtaposent transversalement. Une telle zone est une zone de ruban (ZR) dans laquelle cette plaquette présente les couches successives suivantes :
- une couche d'injection inférieure (25) d'un premier type de conductivité,
- une couche active (14) qui, dans l'étendue de cette zone (ZR), constitue un ruban laser (14A),
- et une couche d'injection supérieure (16) d'un deuxième type de conductivité.

Ces couches constituent un ensemble actif. Elles sont réalisées de manière qu'un courant de polarisation amené par les électrodes (6, 10) injecte verticalement dans ce ruban laser (14A), à partir de ces couches d'injection, des porteurs de charges de types opposés permettant l'amplification d'une lumière laser dans ce ruban. Par ailleurs ce ruban présente un indice de réfraction supérieur à celui des couches environnantes (12, 25, 16, 26, 20, 22) pour constituer un guide pour cette lumière. Les couches d'injection s'étendent transversalement au-delà de cette zone de ruban. La plaquette (2) présente deux successions transversales de zones à partir de chacun de deux côtés de cette zone de ruban (ZR), respectivement. Chaque telle succession comporte d'abord une zone latérale proche (ZC) dans laquelle un canal latéral (CL) prend la place de la couche d'injection supérieure, de la couche active et d'au moins une partie supérieure de la couche d'injection inférieure. Ce canal comporte une couche de blocage inférieure (20) du deuxième type de conductivité surmontée d'une couche de blocage supérieure (22) du premier type de conductivité, de manière que ces deux couches de blocage forment entre elles, vis-à-vis du courant de polarisation, une jonction bloquante (JB) constituant un moyen de blocage de courant rapproché tendant à confiner ce courant dans la zone de ruban (ZR).

La succession transversale de zones comporte ensuite une zone latérale distante (ZD) dans laquelle une couche électriquement résistive constitue un moyen de blocage de courant éloigné coopérant avec le moyen de blocage de courant rapproché pour confiner le courant de polarisation dans la zone de ruban. La réalisation du moyen de blocage de courant éloigné est propre à la présente invention et sera précisée plus loin.

Selon des dispositions communes aux lasers connus et à un laser selon la présente invention les couches de blocage (20, 22) s'étendent dans les zones latérales distantes mais non dans la zone de ruban, ceci résultant de l'utilisation de conditions de dépôt épitaxial convenables lors du dépôt de ces couches. La jonction bloquante qu'elles forment assure un bon blocage du courant dans les canaux parce que leur épaisseur est suffisante. Par contre, ces épaisseurs étant plus minces au niveau des couches latérales distantes, le blocage y est imparfait.

C'est notamment pourquoi il doit être complété par un moyen de blocage de courant éloigné.

La couche d'injection supérieure (16) et ces couches de blocage sont surmontées d'une couche complémentaire plus épaisse du deuxième type de conductivité (26), elle-même surmontée d'une couche de contact plus fortement dopée (28).

Deux réflecteurs non représentés sont formés par les faces longitudinalement extrêmes de la plaquette semi-conductrice pour constituer un émetteur laser.

Un premier laser connu comportant ces éléments et dispositions communs est décrit dans un article du JAPANESE JOURNAL OF APPLIED PHYSICS. vol. 25, n° 6, juin 1986, PART II, TOKYO, JP pages L 435-L436; S.L. SHI ET AL: "BH InGaAsP lasers with an LPE grown semi-insulating layer".

Dans ce laser le courant d'alimentation est bloqué, aussi bien dans la zone latérale proche que dans la zone latérale distante, par la superposition de trois couches réalisées par dépôt épitaxial. Deux de ces couches forment une jonction semi-conductrice bloquante. La troisième comporte des impuretés modificatrices (du cobalt) lui confèrant une résistivité électrique suffisante pour la rendre semi-isolante.

Cette disposition présente l'inconvénient qu'un pincement des couches ainsi déposées peut se produire sur les bords externes des canaux, c'est-à-dire à la frontière entre les zones latérales proche et distante. Un tel pincement empêche le confinement électrique souhaité.

Un deuxième laser connu comportant ces éléments et dispositions communs est décrit dans le document de brevet européen EP-A 161 016 (Philips).

Dans ce deuxième laser connu le moyen de blocage de courant éloigné est formé, après réalisation d'une plaquette telle que précédemment décrite, par un bombardement ionique qui est localisé dans les zones latérales distantes et qui y induit des défauts cristallins augmentant la résistivité du matériau de base. Pour que ce bombardement atteigne une profondeur suffisante les ions utilisés sont des protons. La résistivité électrique ainsi créée dans ces zones peut être initialement suffisamment élevée pour permettre un bon fonctionnement du laser. Mais les défauts cristallins qui en sont la cause se guérissent progressivement lorsque la température de la plaquette s'élève, ce qui diminue la fiabilité et les possibilités d'utilisation du laser.

La présence invention a notamment pour but de permettre une réalisation simple d'un laser fiable, même en cas d'élévation de température, et aisément manipulable, même en cours de fabrication.

Et dans ce but elle a notamment pour objet un laser semi-conducteur à double canal caractérisé par le fait que le confinement du courant électrique d'alimentation dans un ruban laser y est assuré d'une part par un moyen de blocage de courant rapproché formé dans les canaux latéraux qui délimitent ce ruban laser, d'autre part, au-delà d'un tel canal et directement à partir du flanc externe de ce dernier, par une couche semi-isolante interne formée en continuité cristalline avec les couches semi-conductrices du laser.

A l'aide des figures schématiques ci-jointes, on va décrire plus particulièrement ci-après, à titre d'exemple non limitatif, comment la présente invention peut être mise en oeuvre. Lorsqu'un même élément est représenté sur plusieurs figures il y est désigné par le même signe de référence.

La figure 1 représente une vue en coupe transversale d'un premier mode de réalisation d'un laser selon la présente invention.

Les figures 2 à 6 représentent des vues de ce laser en coupe transversale à des étapes successives de sa réalisation.

Les figures 7 à 10 représentent des vues en coupe transversale d'un deuxième mode de réalisation d'un laser selon la présente invention à des étapes successives de sa réalisation.

De manière générale et en se référant à la figure 1, un laser selon l'invention comporte les éléments et dispositions communs précédemment mentionnés. Son moyen de blocage de courant éloigné est constitué par une couche semi-isolante 24 qui présente une continuité cristalline avec un ensemble actif comportant la couche active 14 entre les couches d'injection inférieure 25 et supérieure 16. Plus particulièrement la plaquette semi-conductrice 2 présente, dans chaque zone latérale distante ZD, une succession verticale de couches comportant la couche semi-isolante 24 et l'ensemble actif entre deux couches de confinement optique externe inférieure 12 et supérieure 26 qui encadrent l'ensemble actif et qui, dans la zone de ruban ZR, contribuent, avec les couches d'injection inférieure et supérieure, à confiner la lumière laser dans le ruban laser 14A.

La couche semi-isolante et les couches d'injection inférieure et supérieure sont constituées d'un même matériau de base semi-conducteur, et comportent des impuretés modificatrices différentes choisies pour conférer à ces couches une résistivité et les premier et deuxième types de conductivité, respectivement. Ce matériau de base est le phosphure d'indium ou l'arséniure de gallium et l'impureté modificatrice de la couche semi-isolante comporte du fer, du cobalt, du titane, et/ou du chrome.

Dans les premier et deuxième lasers selon l'invention ce matériau de base est le phosphure d'indium ou l'arséniure de gallium. L'impureté modificatrice de la couche semi-isolante est alors par exemple le fer à une concentration comprise entre 10¹⁶ et 10¹⁸ et typiquement voisine de 10¹⁷ atomes par cm3. L'épaisseur de cette couche est comprise entre 300 et 3000 nm et typiquement voisine de 700 nm. Des impuretés modifications dites "de dopage" de types n et p confèrent les premier et deuxième types de conductivité et sont constituées par le silicium et le zinc ou le béryllium.

Il est à noter que la résistivité électrique apportée par la présence des atomes de fer est une résistivité que l'on peut appeler intrinsèque parce qu'elle ne résulte pas de la formation de défauts géométriques du réseau cristallin et n'est donc pas diminuée par une élévation de la température.

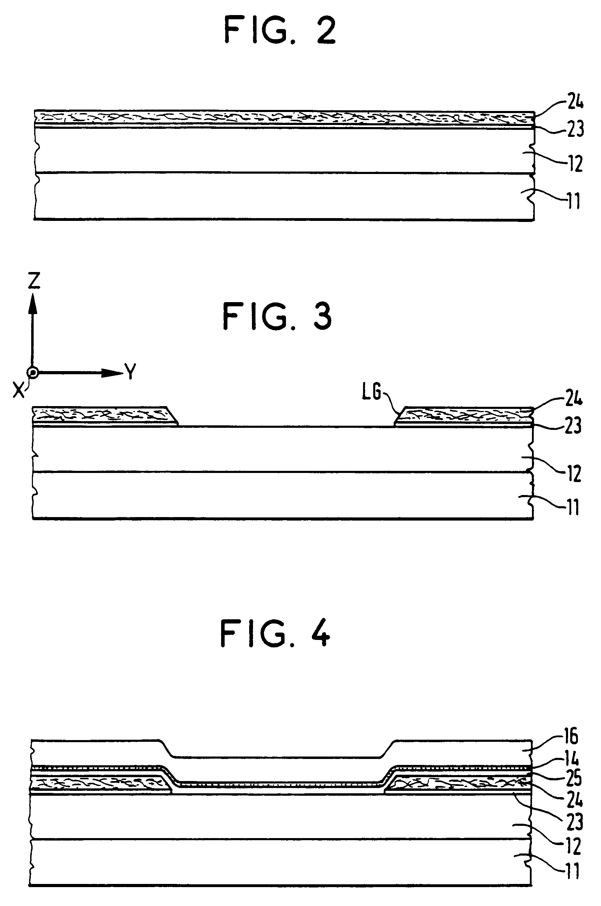

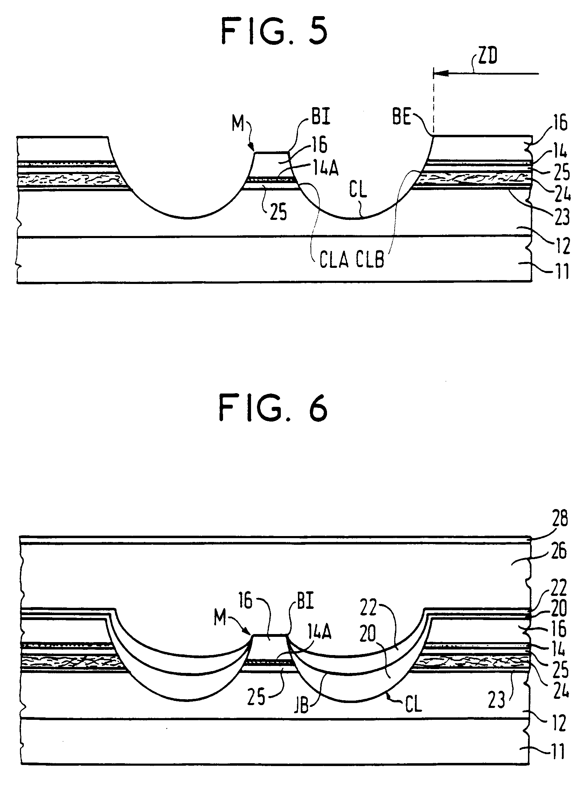

De manière générale un laser selon l'invention peut être réalisé par les opérations suivantes qui sont connues quant à leurs fonctions indiquées et qui sont illustrées par les figures 2 à 6 dans le cas du premier laser selon l'invention :
- Réalisation d'un substrat semi-conducteur 11 portant une couche de confinement optique externe inférieure 12 d'un premier type de conductivité.
- Après réalisation de ce substrat, dépôt épitaxial d'une couche d'injection inférieure 25 du même type de conductivité, puis d'une couche active 14 (voir figure 4) constituée d'un matériau actif propre à amplifier une lumière de laser par recombinaison de porteurs de charges de types opposés.
- Après dépôt de cette couche active, dépôt épitaxial d'une couche d'injection supérieure 16 d'un deuxième type de conductivité de manière qu'un courant d'alimentation circulant ultérieurement de l'une 16 à l'autre 25 des deux couches d'injection injecte dans cette couche active 14 les porteurs de charges de types opposés nécessaires à l'amplification de la lumière laser.
- Après dépôt de la couche d'injection supérieure, gravure de deux canaux CL, (figure 5) s'étendant selon une même direction longitudinale X et éliminant localement la couche d'injection supérieure 16, la couche active 14 et au moins une partie supérieure de la couche d'injection inférieure 25. Les parties des couches précédemment déposées subsistant entre ces canaux constituent une mesa M présentant deux bords BI. La partie de la couche active comprise dans cette mesa constitue un ruban laser 14A par rapport auquel ces canaux constituent des canaux latéraux. Chacun de ces canaux présente un flanc interne CLA constituant un flanc de la mesa, et un flanc externe CLB dont l'arête supérieure constitue un bord externe BE à distance de cette mesa.
- Après gravure de ces canaux latéraux CL, dépôts épitaxiaux d'une couche de blocage inférieure 20 (figure 6) du deuxième type de conductivité puis d'une couche de blocage supérieure 22 du premier type de conductivité, ces dépôts étant réalisés par exemple en phase liquide de manière que ces couches se forment dans ces canaux et s'arrêtent sur les bords BI de la mesa M et qu'une jonction bloquante JB réalisée par ces couches constitue un moyen de blocage de courant rapproché pour empêcher localement le passage du courant de polarisation.

Un moyen de blocage de courant éloigné doit coopérer avec le moyen de blocage rapproché JB pour confiner le courant de polarisation à travers le ruban laser 14A.

Selon la présente invention ce moyen de blocage de courant éloigné est formé par un dépôt épitaxial d'une couche semi-isolante telle que 24 avant la gravure des canaux latéraux. De plus une disposition de localisation de couche semi-isolante est prise pour empêcher que cette couche existe dans une zone de ruban lorsque la fabrication du laser est achevée, cette zone étant la partie de la surface du laser qui comporte le ruban laser.

De préférence le dépôt de la couche semi-isolante est effectué d'une manière non localisée qui forme cette couche aussi dans la zone de ruban, la disposition de localisation de couche semi-isolante étant réalisée par une opération de première gravure de cette couche qui élimine cette couche dans une zone de première gravure de couche semi-isolante, cette zone comportant la zone de ruban et s'étendant transversalement au-delà de cette zone de ruban jusqu'à des limites de première gravure de couche semi-isolante, la gravure des canaux latéraux éliminant une partie supplémentaire de cette couche semi-isolante au voisinage de ces limites.

Le fait que la limite interne de la couche semi-isolante du laser ait été formée par l'opération de gravure des canaux latéraux a pour effet que cette couche part exactement du flanc externe CLB d'un tel canal, ce qui évite tout risque de passage d'un courant électrique parasite entre ce flanc et le bord de cette couche.

Une couche d'arrêt de gravure 23 est déposée avant la couche semi-isolante 24. Elle est par exemple constituée d'un matériau semi-conducteur ternaire. Elle limite la profondeur de la première gravure de la couche semi-isolante. Quant à l'étendue latérale de cette gravure elle est limitée par un masque de type connu. Cette gravure peut faire apparaître, au voisinage des limites LG, des défauts susceptibles de créer ultérieurement des trajets parasites pour le courant de polarisation du laser. Les régions pouvant présenter ces défauts sont éliminées par la gravure ultérieure des canaux latéraux CL.

La première gravure de la couche semi-isolante 24 est facilitée si les directions longitudinale X, transversale Y et verticale Z sont les directions cristallographiques (110), (1-10) et (001) respectivement.

Plus particulièrement, dans le premier laser selon l'invention, la couche semi-isolante 24 est portée par la couche de confinement optique externe inférieure 12 par l'intermédiaire de la couche d'arrêt de gravure 23 et elle est surmontée par la couche d'injection inférieure 25. Cette couche 25 est elle-même surmontée par la couche active 14.

Ce premier laser peut être réalisé comme suit.

Conformément à la figure 2, sur la couche de confinement optique externe inférieure 12, on dépose épitaxialement la couche d'arrêt de gravure 23 et la couche semi-isolante 24. L'impureté de cette dernière est déposée en même temps que son matériau de base, mais pourrait être introduite ultérieurement, par exemple par implantation ionique.

Conformément à la figure 3 on grave les couches 23 et 24 sur une largeur qui est par exemple voisine de 10 000 nm. Cette opération constitue la première gravure de la couche semi-isolante.

Conformément à la figure 4 on effectue une première reprise d'épitaxie, par exemple en phase gazeuse à environ 500 C, pour déposer la couche d'injection inférieure 25, la couche active 14 et la couche d'injection supérieure 16.

Conformément à la figure 5 on grave les deux canaux latéraux tels que CL. L'écart entre leurs deux bords extérieurs tels que BE est par exemple de 20 000 nm. Leurs deux bords intérieurs tels que BI constituent les bords de la mesa M. Leur écart mutuel constitue la largeur de cette mesa. Il est par exemple voisin de 2000 nm.

Conformément à la figure 6 une deuxième reprise d'épitaxie est réalisée en phase liquide pour déposer les couches de blocage inférieure 20 et supérieure 22. Il faut éviter le risque que le liquide d'apport utilisé lors de cette opération déborde sur la mesa. On utilise pour cela le fait, utilisé antérieurement à la présente invention, qu'un tel liquide tend à éviter les saillies à flancs raides et plus particulièrement les saillies situées entre deux flancs raides proches l'un de l'autre comme le sont les flancs de la mesa comportant les bords tels que BI. Mais ce risque est ici augmenté parce que le sommet de la mesa M est plus bas que le plateau formé dans la zone distance ZD par la couche d'injection supérieure que le liquide d'apport doit recouvrir, la différence d'altitude étant approximativement égale à l'épaisseur de la couche semi-isolante 24 précédemment déposée et gravée.

C'est pourquoi d'une part on limite l'épaisseur de cette couche. C'est pourquoi d'autre part on choisit une largeur des canaux latéraux un peu plus grande que les largeurs antérieurement choisies. En raison de cet accroissement de largeur on choisit une durée de dépôt un peu supérieure aux durées antérieurement utilisées.

Au cours de la même reprise d'épitaxie on dépose ensuite les couches 26 et 28.

Il est apparu ci-dessus que, dans la réalisation du premier laser selon la présente invention la couche semi-isolante 24 était déposée avant et était donc finalement située sous l'ensemble actif 25, 14, 16. Au contraire, dans la réalisation du deuxième laser selon cette invention qui va être maintenant décrite, la couche semi-isolante est déposée après et est donc située sur l'ensemble actif.

Chaque élément de ce deuxième laser est généralement fonctionnellement analogue à un élément du premier et porte le même numéro de référence augmenté de 100.

Ce deuxième laser peut être réalisé comme suit.

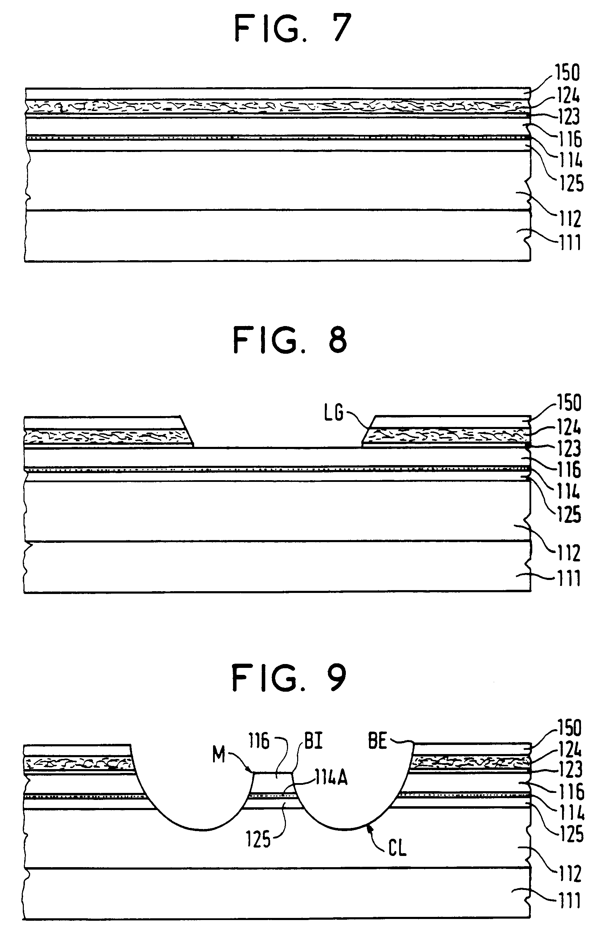

Conformément à la figure 7 une étape d'épitaxie par exemple en phase gazeuse permet de déposer, sur la couche de confinement optique externe inférieure 112 portée par le substrat semi-conducteur 111, la couche d'injection inférieure 125, la couche active 114, la couche d'injection supérieure 116, la couche d'arrêt de gravure 123, la couche semi-isolante 124, et une couche supplémentaire du même type que celui de la couche 116, dite de recouvrement de matériau semi- isolant 150.

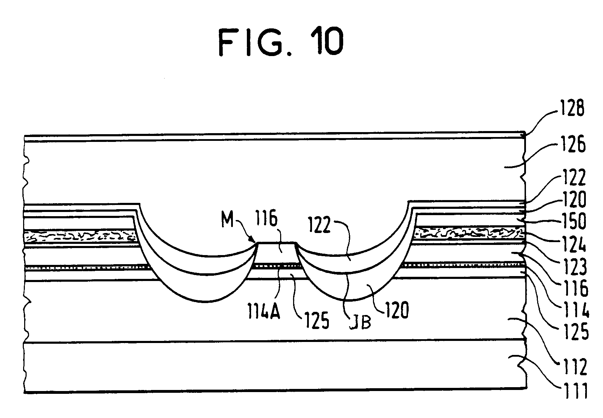

Conformément à la figure 8 on effectue la gravure de ces couches pour découvrir la couche d'injection supérieure 116. Conformément à la figure 9 on grave les canaux latéraux CL. Conformément à la figure 10 une unique reprise d'épitaxie est réalisée par exemple en phase liquide pour déposer les couches de blocage 120 et 122 et les couches de confinement optique externe supérieure 126 et de contact supérieure 128.

## Revendications

1. Laser semi-conducteur à double canal, caractérisé par le fait que le confinement du courant électrique d'alimentation dans un ruban laser (14A) y est assuré d'une part par un moyen de blocage de courant rapproché (JB) formé dans les canaux latéraux (CL) qui délimitent ce ruban laser, d'autre part, au-delà d'un tel canal et directement à partir du flanc externe (CLB) de ce dernier, par une couche semi-isolante interne (24, 124) formée en continuité cristalline avec les couches semi-conductrices (25, 14, 16, 125, 114, 116) du laser.

2. Laser selon la revendication 1, comportant une plaquette généralement semi-conductrice (2) ayant une continuité cristalline interne et présentant deux faces principales qui sont une face inférieure (4) revêtue d'une électrode inférieure (6) et une face supérieure (8) revêtue d'une électrode supérieure (10), cette plaquette définissant une direction verticale ascendante (Z) qui va de cette face inférieure à cette face supérieure, et deux directions longitudinale (X) et transversale (Y) qui sont horizontales et mutuellement perpendiculaires, cette plaquette étant constituée de couches qui se succèdent selon cette direction verticale ascendante, une surface horizontale de cette plaquette comportant des zones diversifiées qui s'étendent longitudinalement et se juxtaposent transversalement, une dite zone étant une zone de ruban (ZR) dans laquelle cette plaquette présente les couches successives suivantes :
- une couche d'injection inférieure (25) qui présente un premier type de conductivité,
- une couche active (14, 114) qui est au contact de cette couche d'injection inférieure et qui, dans l'étendue de cette zone (ZR), constitue un ruban laser (14A, 114A),
- et une couche d'injection supérieure (16, 116) qui est au contact de cette couche active et qui présente un deuxième type de conductivité de manière qu'un courant de polarisation amené par les électrodes (6, 10) injecte verticalement dans ce ruban laser (14A, 114A), à partir de ces couches d'injection (25, 16, 125, 116), des porteurs de charges de types opposés permettant l'amplification d'une lumière laser dans ce ruban, ces couches d'injection inférieure et supérieure et cette couche active constituant un ensemble actif, au moins deux couches de confinement optique inférieure (25, 12, 125, 112) et supérieure (16, 26, 116, 126) étant situées au-dessous et au-dessus de la couche active (14, 114) respectivement, et en interaction optique avec cette couche active, ces couches de confinement optique et des couches de confinement optique latéral (20, 22, 120, 122) situées de part et d'autres du ruban laser (14A, 114A) présentant des indices de réfraction inférieurs à celui de cette couche active pour que ce ruban laser constitue un guide pour cette lumière, ces couches d'injection et de confinement optique s'étendant transversalement au-delà de cette zone de ruban,
cette plaquette (2) présentant deux successions transversales de zones à partir de chacun de deux côtés de cette zone de ruban (ZR), respectivement, chaque telle succession comportant d'abord une zone latérale proche (ZC) dans laquelle un canal latéral (CL) prend la place de la couche active et d'au moins une partie supérieure de la couche d'injection inférieure, ce canal présentant d'une part un flanc interne (CLA) limitant latéralement ledit ruban laser, d'autre part un flanc externe (CLB) opposé à ce flanc interne, ce canal comportant une couche de blocage inférieure (20, 120) du deuxième type de conductivité surmontée d'une couche de blocage supérieure (22, 122) du premier type de conductivité, de manière que ces deux couches de blocage forment entre elles, vis-à-vis du courant de polarisation, une jonction bloquante (JB) constituant un moyen de blocage de courant rapproché s'opposant localement au passage de ce courant,
la succession transversale de zones comportant ensuite une zone latérale distante (ZD) dans laquelle une couche semi-isolante constitue un moyen de blocage de courant éloigné coopérant avec le moyen de blocage de courant rapproché pour confiner le courant d'alimentation dans la zone du ruban, cette couche semi-isolante (24, 124) présentant une continuité cristalline avec les couches d'injection inférieure (25, 125) et supérieure (16, 116) et comportant des impuretés modificatrices lui conférant par leur présence une résistivité électrique intrinsèque, ce laser étant caractérisé par le fait que ladite couche semi-isolante (24, 124) s'étend transversalement dans ladite zone latérale distante à partir dudit flanc externe (CLB) dudit canal latéral (CL).

3. Laser selon la revendication 2, dans lequel la plaquette semi-conductrice (2) présente, dans chaque zone latérale distante (ZD), une succession verticale de couches comportant la couche semi- isolante (24) et l'ensemble actif (25, 14, 16) entre deux couches de confinement optique externe inférieure (12) et supérieure (26) qui constituent deux dites couches de confinement optique.

4. Laser selon la revendication 2, caractérisé par le fait que ladite couche semi-isolante (24) et les couches d'injection inférieure (25) et supérieure (16) sont constituées d'un même matériau de base semi-conducteur, et d'impuretés modificatrices différentes choisies pour conférer à ces couches ladite résistivité et les premier et deuxième types de conductivité, respectivement.

5. Laser selon la revendication 4 dans lequel ledit matériau de base est le phosphure d'indium ou l'arséniure de gallium, caractérisé en ce que l'impureté modificatrice de la couche semi-isolante (24) comporte du fer, du cobalt, du titane, et/ou du chrome.

6. Laser selon la revendication 3, caractérisé par le fait que ladite couche semi isolante (24) est située entre la couche de confinement optique externe inférieure (12) et l'ensemble actif (25, 14, 16).

7. Laser selon la revendication 3, caractérisé par le fait que la couche semi-isolante (124) est située entre l'ensemble actif (125, 114, 116) et la couche de confinement optique externe supérieure (126).

8. Procédé de réalisation d'un laser semi-conducteur à double canal, ce procédé comportant les opérations suivantes :
- réalisation d'un substrat semi-conducteur (11, 111) d'un premier type de conductivité,
- après réalisation de ce substrat, dépôt épitaxial d'une couche d'injection inférieure (25, 125) du premier type de conductivité,
- après dépôt de cette couche d'injection inférieure, dépôt épitaxial d'une couche active (14, 114) constituée d'un matériau actif propre à amplifier une lumière de laser par recombinaison de porteurs de charges de types opposés,
- après dépôt de cette couche active, dépôt épitaxial d'une couche d'injection supérieure (16, 116) d'un deuxième type de conductivité de manière qu'un courant de polarisation circulant ultérieurement de l'une (16, 116) à l'autre (25, 125) des deux couches d'injection injecte dans cette couche active (14, 114) les porteurs de charges de types opposés nécessaires à l'amplification de la lumière laser,
- après dépôt de la couche d'injection supérieure, gravure de deux canaux (CL) s'étendant selon une même direction longitudinale (X) et éliminant localement la couche d'injection supérieure (16, 116), la couche active (14, 114) et au moins une partie supérieure de la couche d'injection inférieure (25, 125) de sorte que les parties des couches précédemment déposées subsistant entre ces canaux constituent une mesa (M) présentant deux bords (BI) et que la partie de la couche active comprise dans cette mesa constitue un ruban laser (14A) par rapport auquel ces canaux constituent des canaux latéraux, chacun de ces canaux présentant un bord externe (BE) à distance de cette mesa,
- après gravure de ces canaux latéraux (CL), dépôts épitaxiaux d'une couche de blocage inférieure (20, 120) du deuxième type de conductivité puis d'une couche de blocage supérieure (22, 122) du premier type de conductivité, ces dépôts étant réalisés de manière que ces couches se forment dans ces canaux et s'arrêtent sur les bords (BI) de la mesa (M) et qu'une jonction bloquante (JB) réalisée par ces couches constitue un moyen de blocage de courant rapproché s'opposant localement au passage du courant de polarisation,
- et, après la réalisation du substrat (11), formation d'une couche électriquement résistive dans des zones latérales distantes (ZD) s'étendant transversalement au delà des bords externes des canaux latéraux de manière à constituer un moyen de blocage de courant éloigné coopérant avec le moyen de blocage de courant rapproché (JB) pour confiner le courant de polarisation à travers le ruban laser (14A, 114A),
- ce procédé étant caractérisé par le fait que le moyen de blocage de courant éloigné est formée par un dépôt épitaxial d'une couche semi-isolante (24, 124) avant la gravure des canaux latéraux (CL), une disposition de localisation de couche semi-isolante étant prise pour empêcher que cette couche (24) existe dans une zone de ruban (ZR) lorsque la fabrication du laser est achevée, cette zone étant la partie de la surface de la plaquette (2) qui comporte le ruban laser (14A).

9. Procédé selon la revendication 8, caractérisé par le fait que le dépôt de la couche semi-isolante (24) est effectué d'une manière non localisée qui forme cette couche aussi dans la zone de ruban (ZR), la disposition de localisation de couche semi-isolante étant réalisée par une opération de première gravure de cette couche qui élimine cette couche dans une zone de première gravure de couche semi-isolante, cette zone comportant la zone de ruban et s'étendant transversalement au-delà de cette zone de ruban jusqu'à des limites de première gravure de couche semi-isolante (LG), la gravure des canaux latéraux (CL) éliminant une partie supplémentaire de cette couche semi-isolante (24) au voisinage de ces limites.

10. Procédé selon la revendication 8, caractérisé par le fait que la couche semi-isolante (24) est formée avant la couche d'injection inférieure (25).

11. Procédé selon la revendication 8, caractérisé par le fait que la couche semi-isolante (124) est formée après la couche d'injection supérieure (116).

## Patentansprüche

1. Halbleiterlaser mit doppeltem Graben, dadurch gekennzeichnet, daß die Einschließung des elektrischen Speisestroms in ein Laserband (14A) einerseits durch ein nahes Stromsperrmittel (JB) gewährleistet wird, das in den das Laserband begrenzenden seitlichen Gräben (C) ausgebildet ist und andererseits jenseits eines solchen Grabens und unmittelbar beginnend an der äußeren Flanke (CLB) dieses Grabens durch eine interne halbisolierende Schicht (24, 124), die in kristalliner Kontinuität mit den Halbleiterschichten (25, 14, 16, 125, 114, 116) des Lasers ausgebildet ist.

2. Laser nach Anspruch 1 mit einem allgemein halbleitenden Plättchen (2), das eine innere kristalline Kontinuität besitzt und zwei Hauptoberflächen aufweist, nämlich eine Unterseite (4), die mit einer unteren Elektrode (6) bedeckt ist, und eine mit einer oberen Elektrode (10) bedeckte Oberseite (8), wobei das Plättchen eine nach oben gerichtete vertikale Richtung (Z) definiert, die von der Unterseite zur Oberseite verläuft, und eine Längsrichtung (X) sowie eine Querrichtung, wobei die beiden letzteren waagrecht verlaufen und aufeinander senkrecht stehen, wobei dieses Plättchen aus Schichten besteht, die in dieser vertikalen ansteigenden Richtung aufeinanderfolgen und wobei eine waagrechte Oberfläche dieses Plättchens diversifizierte Zonen besitzt, die sich in Längsrichtung erstrecken und quer aneinanderliegen, wobei eine dieser Zonen eine Bandzone (ZR) ist, in der das Plättchen die folgenden Schichten übereinander enthält:
- eine untere Injektionsschicht (25) eines ersten Leitfähigkeitstyps,
- eine aktive Schicht (14, 114), die mit dieser unteren Injektionsschicht in Berührung steht und gemäß der Erstreckung dieser Zone (ZR) ein Laserband (14A, 114A) bildet,
- und eine obere Injektionsschicht (16, 116), die mit der aktiven Schicht in Kontakt steht und vom zweiten Leitfähigkeitstyp ist, so daß ein Strom, der von den Elektroden (6, 10) ausgeht, senkrecht in dem Laserband (14A, 114A) ausgehend von diesen Injektionsschichten (25, 16, 125, 116) Ladungsträger entgegengesetzter Typen injiziert, mit denen die Verstärkung eines Laserlichts in diesem Band ermöglicht wird, wobei diese untere und die obere Injektionsschicht sowie die aktive Schicht eine aktive Anordnung bilden und mindestens zwei optische Einschließungsschichten, nämlich eine untere Schicht (25, 12, 125, 112) und eine obere Einschließungsschicht (16, 26, 116, 126) unterhalb und oberhalb der aktiven Schicht (14, 114) und in optischer Wechselwirkung mit dieser aktiven Schicht angeordnet sind, wobei diese optischen Einschließungsschichten und seitliche optische Einschließungsschichten (20, 22, 120, 122), die zu beiden Seiten des Laserbands (14A, 114A) liegen, geringere Brechungsindices als diese aktive Schicht besitzen, so daß das Laserband einen Leiter für dieses Licht bildet, während die Injektions- und optischen Einschließungsschichten sich quer jenseits dieser Bandzone erstrecken,
wobei dieses Plättchen (2) in Querrichtung zwei Folgen von Zonen ausgehend von jeder der beiden Seiten der Bandzone (ZR) besitzt und jede dieser Folgen zuerst eine nahe seitliche Zone (ZC) enthält, in der ein seitlicher Graben (CL) anstelle der aktiven Schicht und mindestens eines oberen Bereichs der unteren Injektionsschicht liegt, wobei dieser Graben einerseits eine innere Flanke (CLA), die seitlich das Laserband begrenzt, und andererseits eine äußere Flanke (CLB) entgegengesetzt zur inneren Flanke besitzt und eine untere Sperrschicht (20, 120) des zweiten Leitfähigkeitstyps und darüber eine obere Sperrschicht (22, 122) des ersten Leitfähigkeitstyps enthält, so daß diese beiden Sperrschichten miteinander gegenüber dem Strom einen Sperrübergang (JB) bilden, der ein Sperrmittel für den nahen Strom darstellt und sich örtlich dem Durchgang dieses Stroms widersetzt,
wobei die Folge von Zonen in Querrichtung weiter eine ferne seitliche Zone (ZD) enthält, in der eine halbisolierende Schicht ein Sperrmittel für den entfernten Strom darstellt, das mit dem Sperrmittel für den nahen Strom zusammenwirkt, um den Speisestrom in der Bandzone zu konzentrieren, wobei diese halbisolierende Schicht (24, 124) eine kristalline Kontinuität mit der unteren Injektionsschicht (25, 125) und der oberen Injektionsschicht (16, 126) bildet und verändernde Verunreinigungen enthält, die durch ihr Vorhandensein einen intrinsischen spezifischen elektrischen Widerstand ergeben, dadurch gekennzeichnet, daß die halbisolierende Schicht (24, 124) sich in Querrichtung in der fernen seitlichen Zone ausgehend von der äußeren Flanke (CLB) des seitlichen Grabens (CL) erstreckt.

3. Laser nach Anspruch 2, in dem das halbleitende Plättchen (2) in jeder seitlichen fernen Zone (ZD) eine vertikale Folge von Schichten mit der halbisolierenden Schicht (24) und der aktiven Anordnung (25, 14, 16) zwischen einer unteren (12) und einer oberen äußeren optischen Einschließungsschicht (26) enthält, die zwei optische Einschließungsschichten bilden.

4. Laser nach Anspruch 2, dadurch gekennzeichnet, daß die halbisolierende Schicht (24) und die untere (25) und die obere Injektionsschicht (16) aus demselben halbleitenden Basismaterial mit unterschiedlichen verändernden Verunreinigungen bestehen, die diesen Schichten den gewünschten spezifischen Widerstand und die Leitfähigkeit vom ersten bzw. zweiten Typ verleihen.

5. Laser nach Anspruch 4, in dem das Basismaterial Indiumphosphid oder Galliumarsenid ist, dadurch gekennzeichnet, daß die verändernden Verunreinigungen der halbisolierenden Schicht (24) Eisen, Kobalt, Titan und/oder Chrom enthalten.

6. Laser nach Anspruch 3, dadurch gekennzeichnet, daß die halbisolierende Schicht (24) zwischen der unteren äußeren optischen Einschließungsschicht (12) und der aktiven Anordnung (25, 14, 16) liegt.

7. Laser nach Anspruch 3, dadurch gekennzeichnet, daß die halbisolierende Schicht (124) zwischen der aktiven Anordnung (125, 114, 116) und der oberen äußeren optischen Einschließungsschicht (126) liegt.

8. Verfahren zur Herstellung eines Halbleiterlasers mit doppeltem Graben, das die folgenden Verfahrensschritte aufweist:
- Herstellung eines Halbleitersubstrats (11, 111) eines ersten Leitfähigkeitstyps,
- nach der Herstellung dieses Substrats, epitaxiales Aufwachsen einer unteren Injektionsschicht (25, 125) des ersten Leitfähigkeitstyps,
- nach dem Aufbringen dieser unteren Injektionsschicht, epitaxiales Aufwachsen einer aktiven Schicht (14, 114), bestehend aus einem aktiven Material, das zur Verstärkung eines Laserlichts durch Rekombination von Ladungsträgern entgegengesetzter Typen geeignet ist,
- nach dem Aufbringen dieser aktiven Schicht, epitaxiales Aufwachsen einer oberen Injektionsschicht (16, 116) eines zweiten Leitfähigkeitstyps, derart, daß ein Strom, der später von der einen (16, 116) zur anderen Injektionsschicht (25, 125) fließt, in dieser aktiven Schicht, (14, 114) die Ladungsträger entgegengesetzter Typen injiziert, die für die Verstärkung des Laserlichts erforderlich sind,
- nach dem Aufbringen dieser oberen Injektionsschicht, Ausätzen von zwei Gräben (CL), die sich in einer gemeinsamen Längsrichtung (X) erstrecken, wobei die obere Injektionsschicht (16, 116), die aktive Schicht (14, 114) und mindestens ein oberer Bereich der unteren Injektionsschicht (25, 125) örtlich entfernt werden, so daß die zwischen diesen Gräben verbleibenden, vorher aufgebrachten Schichten einen Tisch (M) bilden, der zwei Ränder (BI) besitzt, und daß der Teil der aktiven Schicht in diesem Tisch ein Laserband (14A) bildet, bezüglich dem die Gräben seitliche Gräben bilden, wobei diese Gräben einen äußeren Rand (BE) in einem Abstand vom Tisch aufweisen,
- nach dem Ausätzen dieser seitlichen Gräben (CL), epitaxiales Aufwachsen einer unteren Sperrschicht (20, 120) vom zweiten Leitfähigkeitstyp, dann einer oberen Sperrschicht (22, 122) vom ersten Leitfähigkeitstyp, wobei diese Schichten so hergestellt werden, daß sie sich in diesen Gräbenn ausbilden und an den Rändern (BI) des Tisches (M) Halt machen und daß ein Sperrübergang, der zwischen diesen Schichten besteht, ein Sperrmittel für den nahen Strom bildet, das sich örtlich dem Durchgang des Stroms widersetzt,
- und nach der Herstellung des Substrats (11), Bildung einer Schicht mit einem spezifischen elektrischen Widerstand in den fernen seitlichen Zonen (ZD), die sich in Querrichtung jenseits der äußeren Ränder der seitlichen Gräben erstrecken, so daß sie ein Sperrmittel für den entfernten Strom bilden, das mit dem Sperrmittel für den nahen Strom (JB) zusammenwirkt, um den Strom durch das Laserband (14A, 114A) zu konzentrieren,
- dadurch gekennzeichnet, daß das Sperrmittel für den fernen Strom von einer vor dem Ausätzen der seitlichen Gräben (CL) epitaxial aufgebrachten halbisolierenden Schicht (24, 124) gebildet wird, wobei eine Maßnahme zur Lokalisierung der halbisolierenden Schicht getroffen wird, um zu verhindern, daß diese Schicht (24) in einer Zone des Bandes (ZR) nach Abschluß der Laserherstellung existiert, wobei diese Zone der Teil der Oberfläche des Plättchens (2) ist, der das Laserband (14A) enthält.

9. Verfahren nach Anspruch 8, dadurch gekennzeichnet, daß das Aufbringen der halbisolierenden Schicht (24) auf eine örtlich nicht beschränkte Weise erfolgt, durch die diese Schicht auch in der Bandzone (ZR) gebildet wird, wobei die Maßnahme zur Lokalisierung der halbisolierenden Schicht durch eine erste Ätzphase erfolgt, in der diese Schicht in einer Zone der ersten Ätzphase der halbisolierenden Schicht entfernt wird, die die Bandzone einschließt und sich quer über diese Bandzone hinaus bis zu den Grenzen der ersten Ätzphase der halbisolierenden Schicht (LG) erstreckt, während beim Ätzen der seitlichen Gräben (CL) ein zusätzlicher Teil dieser halbisolierenden Schicht (24) in der Nähe dieser Grenzen beseitigt wird.

10. Verfahren nach Anspruch 8, dadurch gekennzeichnet, daß die halbisolierende Schicht (24) vor der unteren Injektionsschicht (25) gebildet wird.

11. Verfahren nach Anspruch 8, dadurch gekennzeichnet, daß die halbisolierende Schicht (124) nach der oberen Injektionsschicht (116) gebildet wird.

## Claims

1. Double channel semiconductor laser characterised in that the energisation electrical current is confined within a laser stripe (14A) by near current blocking means (JB) formed in lateral channels (CL) which delimit said laser stripe and beyond said channels and directly from the outer flank (CLB) thereof by an internal semi-insulative layer (24, 124) whose crystal lattice is continuous with the semiconductor layers (25, 14, 16, 125, 114, 116) of the laser.

2. Laser according to claim 1 comprising a usually semiconductor wafer (2) having internal crystal lattice continuity and two main surfaces, a lower surface (4) covered with a lower electrode (6) and an upper surface (8) covered with an upper electrode (10), said wafer defining an upward vertical direction (Z) from said lower surface to said upper surface and a longitudinal direction (X) and a transverse direction (Y) which are horizontal and mutually perpendicular, said wafer comprising layers in succession in said upward vertical direction, a horizontal surface of said wafer comprising diversified areas extending longitudinally and juxtaposed transversely, one of said areas being a stripe area (ZR) in which said wafer comprises the following successive layers:
- a lower injection layer (25) which has a first type of conductivity,
- an active layer (14, 114) in contact with said lower injection layer and which constitutes a laser stripe (14A, 114A) in said area (ZR), and
- an upper injection layer (16, 116) in contact with said active layer and which has a second type of conductivity so that a polarising current connected via said electrodes (6, 10) injects vertically into said laser stripe (14A, 114A) from said injection layers (25, 16, 125, 116) charge carriers of opposite types enabling amplification of laser light in said stripe, said lower and upper injection layers and said active layer constituting an active system, optical confinement layers comprising at least an upper confinement layer (16, 26, 116, 126) and a lower optical confinement layer (25, 12, 125, 112) being disposed below and above said active layer (14, 114), respectively, and interacting optically with said active layer, said optical confinement layers and lateral optical confinement layers (20, 22, 120, 122) disposed to either side of said laser stripe (14A, 114A) having refractive indices lower than that of said active layer so that said laser stripe constitutes a light guide, said injection layers and optical confinement layers extending transversely beyond said stripe area, said wafer (2) having two transverse successions of areas each running from a respective side of said stripe area (ZR), each such succession comprising firstly a near lateral area (ZC) in which a lateral channel (CL) is substituted for said active layer and at least an upper part of said lower injection layer, said channel having an inner flank (CLA) delimiting laterally said laser stripe and an outer flank (CLB) opposite said inner flank, said channel comprising a lower blocking layer (20, 120) having said second type of conductivity on top of which is an upper blocking layer (22, 122) having said first type of conductivity whereby said two blocking layers form between them, with respect to said polarising current, a blocking junction (JB) constituting near blocking current means locally opposing the flow of said current, the transverse succession of areas secondly comprising a far lateral area (ZD) in which a semi-insulative layer constitutes far current blocking means cooperating with said near current blocking means to confine said polarising current in said stripe area, said semi-insulative layer (24, 124) having a crystal lattice continuous with said lower injection layer (25, 125) and said upper injection layer (16, 116) and comprising modifying impurities conferring on it an intrinsic electrical resistivity, said laser being characterised in that said semi-insulative layer (24, 124) extends transversely in said far lateral area from said external flank (CLB) of said lateral channel (CL).

3. Laser according to claim 2 wherein said semiconductor wafer (2) has in each far lateral area (ZD) a vertical succession of layers comprising said semi-insulative layer (24) and said active system (25, 14, 16) between lower and upper external optical confinement layers (12, 26) which constitute two of said optical confinement layers.

4. Laser according to claim 2 characterised in that said semi-insulative layer (24) and said lower and upper injection layers (25, 16) are made from the same semiconductor base material and comprise different modifying impurities chosen to confer upon said layers resistivity and respectively said first and second types of conductivity.

5. Laser according to claim 4 wherein said base material is indium phosphide or gallium arsenide and said modifying impurity of said semi-insulative layer (24) comprises iron, cobalt, titanium and/or chromium.

6. Laser according to claim 3 characterised in that said semi-insulative layer (24) is between said lower external optical confinement layer and (12) said active system (25, 14, 16).

7. Laser according to claim 3 characterised in that said semi-insulative layer (124) is between said active system (125, 114, 116) and said upper external optical confinement layer (126).

8. Method of fabricating a double channel semiconductor laser comprising the following operations:
- fabricating a semiconductor substrate (11, 111) having a first type of conductivity,
- after fabricating said substrate, epitaxially growing a lower injection layer (25, 125) having said first type of conductivity,
- after growing said lower injection layer, epitaxially growing an active layer (14, 114) comprising an active material adapted to amplify laser light by recombination of opposite type charge carriers,
- after growing said active layer, epitaxially growing an upper injection layer (16, 116) having said second type of conductivity whereby a polarisation current flowing subsequently between said two injection layers (16, 116; 25, 125) injects into said active layer (14, 114) the charge carriers of opposite type needed to amplify the laser light,
- after growing said active layer, etching two channels (CL) in the same longitudinal direction (X) and locally eliminating said upper injection layer (16, 116), said active layer (14, 114) and at least an upper part of said lower injection layer (25, 125) so that the parts of the layers previously grown remaining between said channels constitute a mesa (M) having two edges (BI) and the part of the active layer included in said mesa constitutes a laser stripe (14A) with respect to which said channels constitute lateral channels, each of said channels having an outer edge (BE) spaced from said mesa,
- after etching said lateral channels (CL), epitaxially growing a lower blocking layer (20, 120) having said second type of conductivity and then an upper blocking layer (22, 122) having said first type of conductivity, said growth stages being carried out in such a way that said layers are formed in said channels and stop at the edges (BI) of said mesa (M) and so that a blocking junction (JB) formed by said layers constitutes near current blocking means locally opposing the flow of said polarising current, and
- after fabricating said substrate (11), forming an electrically resistive layer in far lateral areas (ZD) extending transversely beyond the outer edges of said lateral channels so as to constitute far current blocking means cooperating with said near current blocking means (JB) to confine said polarisation current to said laser stripe (14A, 114A):
- said method being characterised in that the far current blocking means are formed by epitaxially growing a semi-insulative (24, 124) layer before etching said lateral channels (CL), said semi-insulative layer (24) being localised to prevent it being present in a stripe area when (ZR) fabrication of the laser is completed, said stripe area being the part of the surface of said wafer (2) which incorporates said laser stripe (14A).

9. Method according to claim 8 characterised in that said semi-insulative layer (24) is grown in a non-localised way so that said layer is formed also in said stripe area (ZR), the localisation of said semi-insulative layer being achieved by a first etching of said layer which eliminates said layer in a semi-insulative layer first etch area comprising the stripe area and extending transversely beyond said stripe area as far as semi-insulative area first etch boundaries (LG), the etching of said lateral channels (CL) eliminating a further part of said semi-insulative layer (24) near said boundaries.

10. Method according to claim 8 characterised in that said semi-insulative layer (24) is formed before said lower injection layer (25).

11. Method according to claim 8 characterised in that said semi-insulative layer (124) is formed after said lower injection layer (116).
